# EUROPEAN PATENT SPECIFICATION

(11) **EP 2 597 174 B1**
(45) Date of publication and mention of the grant of the patent: **10.05.2017**
(21) Application number: 12193857.5
(22) Date of filing: 22.11.2012
(51) Int. Cl.: C23C 14/24, C23C 14/00, C23C 14/32

(54) **Vapor deposition of ceramic coatings**
Dampfabscheidung von keramischen Beschichtungen
Dépôt en phase vapeur de revêtements céramiques

(30) Priority: 23.11.2011 US 201113303232
(43) Date of publication of application: 29.05.2013
(73) Proprietor: United Technologies Corporation, Farmington, CT 06032 (US)
(72) Inventor: Belousov, Igor V., 08650 Kyiv's Region (UA); Kononenko, Yuriy G., 01021 Kyiv (UA); Kuzmichev, Anatoly, 02192 Kiev (UA); Mullooly, Jr., John E., Oklahoma City, OK Oklahoma 73150 (US)
(74) Representative: Leckey, David Herbert

(56) References cited:
- EP-A1- 0 166 349
- JP-A- 59 200 758
- JP-A- 60 092 470
- JP-A- 62 180 068
- JP-A- H06 108 235
- JP-B2- 3 458 585

## Description

### BACKGROUND

The disclosure relates to ceramic coatings. More particularly, the disclosure relates to physical vapor deposition of ceramic coatings.

Many gas turbine engine components are subject to high temperatures. Typically, such components are formed of coated metallic substrates. Exemplary substrates are nickel-based superalloys. Exemplary coatings are multilayer ceramic thermal barrier coatings (TBC).

Various deposition systems and techniques have been proposed for applying such coatings. These techniques include electron beam physical vapor deposition (EB-PVD). In EB-PVD, an electron beam is used to evaporate the coating material from an ingot. An exemplary ingot has a nominal composition the same as the composition of the coating layer to be deposited. However, some species from the ingot may become depleted from the vapor stream. Most notably, oxygen may be lost from ingots containing zirconia (ZrO₂). In a reactive EB-PVD system, reactive gas (i.e., oxygen) is added to make up for oxygen depleted from the ingot.

In a basic EB-PVD process, evaporated ceramic species arrive at the substrate with thermal energy corresponding to the evaporation temperature of the ingot material. This energy level may be too low to form a desirably dense, well-bonded, and erosion-resistant coating. Use of supplemental substrate heating only partially addresses this problem. Increasing the evaporation rate and vapor temperature may also be employed. However, increased rate and temperature may cause splashing of liquid material and spitting of solid material with splashes and spits reaching the substrate and causing coating inhomogeneities/defects. JP09228033 A discloses a method for handling impurities in a rotating crucible during deposition by vacuum evaporation.

An apparatus for evaporating material from a rotating crucible is disclosed in JP-A-62180068.

### SUMMARY

According to the present invention there is provided a method of applying a coating to a substrate as set forth in claim 1.

The details of one or more embodiments are set forth in the accompanying drawings and the description below. Other features, objects, and advantages will be apparent from the description and drawings, and from the claims.

### BRIEF DESCRIPTION OF THE DRAWINGS

FIG. 1 is a partially schematic view of a deposition system.
FIG. 2 is an enlarged view of a pool region of the system.
FIG. 3 is a partially schematic view of plasmatron for oxygen plasma generation.

Like reference numbers and designations in the various drawings indicate like elements.

### DETAILED DESCRIPTION

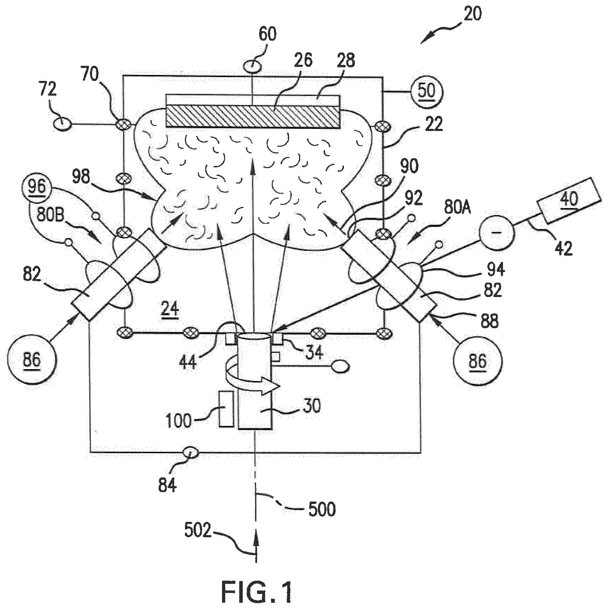

FIG. 1 shows a deposition system 20 including a chamber 22 having an interior 24. A substrate 26 is held within the chamber by a substrate holder 28 (e.g., a clamping fixture, a rack, or the like). An exemplary substrate is a gas turbine engine component (e.g., of a nickel-based superalloy).

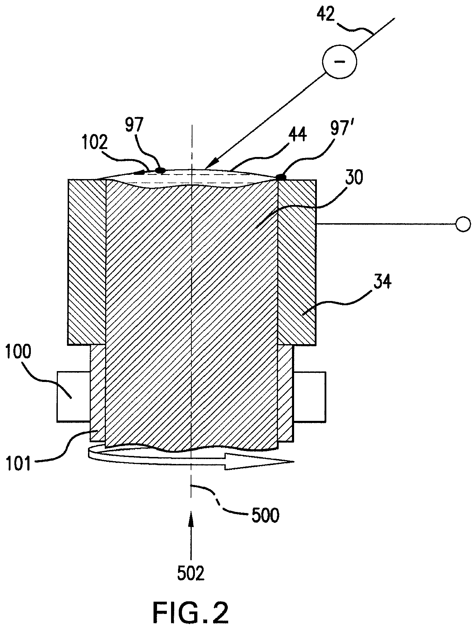

A source of deposition material (coating material) includes an ingot 30 having an axis 500. The exemplary deposition material and ingot are ceramics (e.g., comprising at least 50% by weight one or more components selected from the group consisting of gadolinium stabilized zirconia (GSZ) and yttria stabilized zirconia (YSZ)). A more particular exemplary material consists essentially of 7YSZ crucible. The ingot is held for progressive insertion into the chamber interior in an axial direction 502. The exemplary ingot has an upper end received within a crucible 34. An electron beam gun 40 is positioned to direct an electron beam 42 to the crucible. More particularly, the beam 42 may initially be directed to the upper end of the ingot which, upon sufficient heating, is melted to form a melt pool 44. The beam may continue to be directed to the melt pool 44 to maintain heat in the melt pool. Additionally, there may be supplemental heating via the crucible. A vacuum source 50 (e.g., one or more vacuum pumps) may be coupled to the chamber to evacuate and maintain the chamber interior at a desired low pressure. FIG. 2 depicts the ingot/crucible unit in more detail.

FIG. 1 further shows a bias voltage source 60 for applying a bias voltage (*U*_{B}) to the substrate. An RF antenna 70 is coupled to a voltage source 72 for receiving an RF voltage *U*_{A}. The RF antenna 70 surrounds the space between the crucible 34 (the pool 44 on the ingot top surface 30) and the substrate so that it surrounds the space where evaporated species flow toward the substrate. The RF antenna 70 may be of different types. An exemplary type is an RF inductor surrounding the space between the ingot and the substrate. It may be a single inductor or several partial inductors connected in parallel and disposed in series along the space between the ingot and the substrate. The RF inductor may be made from copper pipe cooled by water. An exemplary operational frequency of the voltage source 72 is in the range 0.066-40.68 MHz (more narrowly, 0.44-13.56 MHz); an exemplary operational value of the RF voltage *U*_{A} is in the range 0.1-10.0 kV (more narrowly, 1-5 kV). The use of the antenna 70 for plasma generation within the chamber 22 is discussed below.

FIG. 1 further shows autonomic reactive plasma generators/plasmatrons (as an exemplary variant, a pair of plasmatrons 80A&80B, collectively 80), set up within the chamber 22 or on its walls. Each plasmatron comprises a body 82. A plasmatron voltage source 84 applies a voltage *U* across the two plasmatron bodies. Exemplary voltage *U* is of radio-frequency - RF (> 1 MHZ) or middle-frequency - MF (0.1-1,0 MHz), or low-frequency - LF (1-100 kHz), or alternating-current - AC (<1 KHz), or direct-current - DC voltage. The exemplary frequency is 0.066-13.56 MHz (more narrowly, 0.44-13.56 MHz). The operational value of the voltage *U* is in the range 0.1-10.0 kV (more narrowly, 1-5 kV). The plasmatrons 80 fill in the chamber interior 24 by plasma containing reactive species participating in synthesis of the ceramic coatings on the substrate surface. Below, the operation of these plasmatrons is discussed.

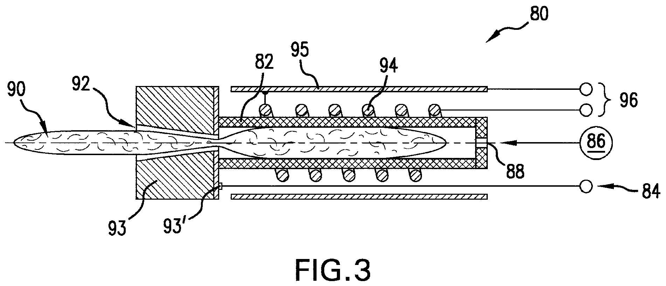

Each plasmatron further includes an oxygen source 86 for directing an oxygen flow to an inlet 88. An oxygen plasma 90 is discharged from an outlet 92 of a nozzle 93, which is an end part of the plasmatron body 82 (see FIG. 3 and description of it below). An exemplary operational gas pressure within the plasmatrons 80 is 1.0-10.0 Pa (more narrowly, 2.0-5.0 Pa) and the plasmatrons are able to generate a sufficiently dense oxygen plasma. The plasmatrons 80 must have long lifetimes in reactive gas environment and at high-temperature conditions in the chamber 22, therefore their parts (electrodes, envelopes, etc.) are built from chemically-resistant and thermally-stable materials such as from inorganic dielectrics (e.g., silica, alumina, zirconia, etc.). The exemplary plasmatrons are essentially identical to each other so as to facilitate their cooperative use with the voltage *U* being applied across their respective bodies. The plasmatrons may be of different kind, however an exemplary variant is an electrodeless tube-like system with an external electromagnetic field exciter-adapter/antenna. Therefore each plasmatron includes an adapter 94 for igniting and maintaining reactive plasma generating radio-frequency (RF) or microwave (MW) gas discharge within the plasmatron. Each plasmatron further includes a RF/MW power source 96 applying an electromagnetic power across the adapter/antenna 94. An exemplary operational frequency of the power source 96 is in the RF range 0.066-40,68 MHz or MW range of 0.9-5 GHz. An exemplary operational value of the RF voltage on the adapter/antenna is in the range 0.1-10.0 kV (more narrowly, 1-3 kV). An exemplary RF or MW power supplying the plasma discharge within the plasmatrons is 0.1-5.0 kW (more narrowly, 0.5-2.0 kW). The type of adapter/antenna depends on the values of operation frequency and power. For RF frequencies, the exemplary type is an induction coil or a capacitor-like adapter, comprising, for example, a pair of metallic rings surrounding the plasmatron body 82 (the capacitor-like adapter is shown schematically in FIG. 1). For MW range, the exemplary type is of waveguide or resonator adapter/applicator.

FIG. 3 depicts the induction-type plasmatron 80 in more detail. An induction-adapter/antenna (inductor) 94 from copper pipe is turned around the plasmatron body 82. The inductor 94 generates within it the oxygen plasma 90 ejected through the outlet 92 of the nozzle 93 into the chamber interior 24. Oxygen (O₂) is supplied by the oxygen source 86 through the inlet 88. The downstream/distal end winding (left in the figure) of the inductor is connected to a shield/back-conductor 95, which, in turn, surrounds the inductor 94. The shield 95 prevents deposition of evaporated material onto the inductor and the plasmatron body and their overheating by IR radiation from the melted ingot.

The inductor 94 and the back-conductor 95 are cooled by water. The upstream/proximal end winding (right in the figure) of the inductor 94 together with the back-conductor 95 are connected to the RF power source 96. This source maintains an RF electrical oxygen-plasma-generating discharge within the plasmatron body (tube) 82. The plasmatron tube as the whole or its part surrounded by the inductor 94 may be made from dielectric material (see text above) for allowing penetration of the electromagnetic field (generated by the inductor) into the plasmatron tube cavity.

The nozzle 93 may be also be made from dielectrics but an exemplary nozzle is built from conductive material (e.g., conductive ceramics) when the voltage *U* is applied between the plasmatrons. In the latter case the nozzle may have an electrical contact 93', connected to the power source 84. The exemplary material for the nozzle is zirconia, which is conductive at the high temperatures occurring within the chamber (e.g., above 1000C). To maintain ceramic nozzle conductivity, the exemplary nozzle 93 is not surrounded by a heat shield in FIG. 3. Condensation of zirconia vapor on the external surface of zirconia nozzle does not affect normal plasmatron operation. The condensation of zirconia on the internal nozzle surface is avoided due to flow of the oxygen plasma jet from the outlet 92.

In operation, cost efficiency suggests seeking a high deposition rate. This may be achieved via high power to the electron beam gun. The very high electron beam power leads to two problems. The first problem is to retain properties of high quality coatings as when deposited with a relatively low power evaporating electron beam (that is retaining good adhesion and dense stable microstructure). This problem is solved by ion/plasma-enhanced reactive EB-PVD process that is by the effect of plasma particles upon the deposited ceramic material with energy, which is higher than the thermal energy of evaporated species. Input of energy with reactive plasma particles (mainly, with ions, accelerated by negative bias potential applied to the substrate) promotes sintering of deposited ceramic species and obtaining dense structure with good operational properties.

However, there is a second problem in that high power of the evaporating electron beam may produce splashing of melted ceramic which may reach the substrate. Additionally, small solid pieces (spits) of ceramic may be ejected from the ingot and pool and may reach the substrate. This may cause undesirable structural defects compromising coating properties.

Non-melted pieces of solid slag 97 (FIG. 2), coming up to the pool surface from ingot material, as well any solid particles falling down upon the pool from the chamber walls and substrate fixture may provoke a splash/spit generation. The high-power electron beam 42, scanning over the pool surface, overheats floating solid pieces/particles and causes explosive boiling of both the coating material, near the overheated pieces, and the slag pieces. As a result, explosively generated droplets and fine solid species are otherwise ejected toward the substrate.

As is discussed below, the splattering/spitting may be addressed via use of the aforementioned electrical hardware and the centrifugal rotation of the ingot.

An electrical method of countering splattering/spitting is heating and evaporating ceramic spits with plasma particle bombardment as the spits fly through the plasma medium generated in the volume between the ingot and the substrate. Therefore, one would provide a chamber with a path of spits through the plasma medium as long as possible. However, the maximum path length is determined by the maximum permissible distance "ingot-substrate", tailored as a compromise between decreasing the deposition rate and increasing the uniformity of deposited coating thickness when the distance is increased. In practice, the distance is 20-70 cm. As a consequence, one would provide a plasma process with plasma particle density as high as possible to provide sufficient plasma heating.

To provide such a process, the reactive gas (oxygen in the case of ZrO₂+7%Y₂O₅ (7YSZ) deposition) is introduced into the chamber. To generate reactive gas plasma, two types of gas discharge units are employed: RF/MW plasmatrons 80, which operate with oxygen as a working gas and inject oxygen plasma 90 into the space between the ingot 30 and substrate 26; and RF antenna 70 for ionizing and exciting oxygen gas plasma media 98, filling in an interior of the chamber. RF/MW power is applied to the plasmatrons 80 and RF voltage *U*_{A} is applied to the antenna 70. Thus, oxygen gas is introduced into the chamber through the plasmatrons, which provide primary ionizing and exciting oxygen and generate so-called primary oxygen plasma 90 within the chamber.

As was mentioned above, the voltage source 84 may be connected to the plasmatrons 80. As a result, a gas discharge is supported between the plasmatrons 80. As operational gas pressure (e.g., ∼1.0-10.0 Pa) within the plasmatrons 80 may be much higher than gas pressure within the chamber (∼ 0.01-0.1 Pa), the plasmatrons are able to generate a sufficiently dense jets/streams of oxygen plasma injected into the space between the ingot and substrate. The voltage source 84, namely, in this jet/stream, supports the gas discharge above the crucible and the ingot pool. Also, a voltage *U*_{I} (RF, MF, LF, AC or DC voltage) may be applied to the ingot, relative to the chamber walls or relative to the plasmatrons 80 (e.g., nozzles 93 of plasmatrons 80, *see*, FIG. 3), to enhance charged particle generation just above the pool. Maintaining discharge on the ingot surface is possible due to electrical conductivity of the ingot material (e.g., YSZ ceramics) heated to high temperature by EB bombardment. Ultimately, the voltages applied between the plasmatrons (*U*) and to the ingot (*U*_{I}) enhance the charge particle generation in the space between the plasmatrons and above the ingot.

The substrate is surrounded by plasma that is generated within the chamber interior 24. The plasma serves as a source of chemically active species for full oxidation of the deposited TBC material and simultaneously as a source of ions for bombardment of deposited TBC. Both the plasma oxidation and the ion bombardment promote modification of TBC material to obtain stoichiometric chemically stable composition, dense structure with good operational properties. Such properties include thermal, erosion, and mechanical TBC stability (resistance), excellent adhesion, etc.

Negative bias voltage *U*_{B} is applied to the substrate for acceleration of the plasma ions to it. The employed ions (O⁺, O₂⁺, ZrₓO_{y}⁺, etc.) correspond to the chemical elements or molecules and radicals forming TBC (that is O O₂, ZrₓO_{y}, YₓO_{y} etc. in the case of ZrO₂+7%Y₂O₅ (7YSZ) composition of TBC). The acceleration of ions brings kinetic energy into the process of forming a high-quality TBC along with chemical energy of active plasma species (radicals, e.g. O, and excited particles, e.g. O*, O₂*, etc.) Thus, different chemically active electrically neutral and high-energy charged species affect the growing TBC and promote obtaining better operation properties of TBCs.

The primary plasma 90, generated with plasmatrons 80, as well as the secondary plasma (generated between the plasmatrons and between the plasmatrons and the ingot) are a source of charged particles for promoting of igniting and supporting the RF plasma discharge 98 with help of antenna 70. The latter discharge may be called as a secondary discharge or a non-self maintaining one. Due to such approach the density of the plasma 98, filling in an interior of the chamber, strongly increased. The density of the plasma 98 at low reactive gas pressure (≤ 0.1 Pa) without the primary plasma 90 would be very low for effective ceramic spit heating by plasma species and subsequent spit evaporation on their way to substrate.

The primary plasma 90 and the secondary plasma 98 form a medium, in which ceramic spits, ejected by the melted ceramic ingot surface, are heated due to their bombarding by high-energy plasma species. High temperature heating leads to evaporation of spits and elimination of them from vapor flow directed to the substrate. To provide such heating, the sufficiently dense plasma with high charged particles concentration must be generated from relatively low pressure (≤ 0.1 Pa) gas.

The mechanism of spit heating is believed as follows: each spit, being a material piece, collects electrons and ions; because average plasma electron energy is much higher than average plasma ion energy and plasma electron current density is higher than ion density, the spits take some equilibrium negative potential, at which the electron current is equal to the ion current. Both types of charged plasma particles - electrons and ions - give their energy to spits and heat them to a higher temperature than the temperature obtained during ejection from the pool. The denser the plasma, the higher the electron and ion currents to the spit and the stronger spit heating are. Also, the larger way or path length of spits through the plasma medium, the longer the time period of additional heating is, and the more mass of any spit is evaporated. Employing two plasmas (90 and 98) allows increasing the path length of the spits between the ingot and the substrate in the plasma medium (e.g., to be nearly equal to the full distance from the ingot to the substrate). Thus, the denser the plasma along the spit path and longer the path, the less probability of spits reaching the substrate.

The centrifugal action is also used to prevent such splatters and solid particles from reaching the substrate. This may involve rotating the melt pool and the ingot (FIG. 2). An exemplary rotation is driven by an actuator 100 (e.g., an electrical motor with gear mechanism (not shown)) which rotates the ingot carrier 101 (and may be assembled with the crucible) as a unit at an angular velocity ω. The imparting of angular velocity will cause any slag species/pieces floating on the pool surface to go off radially toward the pool periphery and a solid boundary/edge/shore of the pool.

FIG. 2 shows (as an example) a slag piece 97 floating near the middle of the pool and a slag piece 97' at the pool periphery. The arrow 102 depicts the action direction of the centrifugal force F. Due to this, the pool surface is cleaned of any solid species; therefore, one reduces instances of hitting slag pieces by electron beam 42 scanning over the pool surface. This avoids overheating the slag pieces and explosive boiling of both the coating material and the slag matter. As a result, droplets and solid species do not deposit on the substrate.

The centrifugal force is determined by the equation *F=M*ω²*R,* where *M* is mass of a ceramic spit or a solid piece, ejected from the ingot, ω - angle rate of rotation, *R* - radius of rotation. The evaporating EB is scanned over the upper ingot surface (or pool surface once the pool forms) and usually goes partially over the metallic water-cooled crucible to provide more uniform heating. The probability of slag location is higher at the pool periphery (on the frozen solid edge/shore just above the top crucible surface) but there EB heating is weak due to strong heat removal into the water-cooled crucible and probability of slag species ejection by EB explosion from here is minimal. An exemplary outboard peripheral spreading of the pool over the top crucible surface where the frozen slag is located comprises at least an outboard (2-10)% of the ingot radius, more narrowly, at least 3-7% or at least 5%.

Moreover, the rotation radius *R* of future drops and solid pieces and, hence, the centrifugal force, acting on drops and solid pieces located near the pool periphery, are maximum. To further maximize the effect, the ingot rotation rate ω may be maximized. However, ω is limited by technical possibilities of high rate ingot rotation and confining the melt in the steady state on the solid ingot surface. Taking all this into account, the angular rate of ingot rotation ω is defined experimentally for the given TBC coater. Exemplary ω is 0.1-60.0 turns/minute, more narrowly, 0.5-10.0 turns/minute.

One or more embodiments have been described. Nevertheless, it will be understood that various modifications may be made. For example, implemented in the reengineering of an existing system or the deposition of a particular coating, details of the existing system or the particular coating may influence details of any given implementation. Accordingly, other embodiments are within the scope of the following claims.

## Claims

1. A method of applying a coating to a substrate: the method comprising:
i) providing an apparatus having:
a deposition chamber (22);
a cooled crucible (34) for holding a melt pool (44) of coating material; and
means (100) for rotating the melt pool (44)
ii) melting an ingot (30) in the crucible to form the melt pool (44); and
iii) controlling the means (100) to rotate the melt pool (44) so as to move slag floating on the pool surface radially towards the pool periphery and to freeze the slag.

2. The method of claim 1 wherein:
the melting comprises heating the melt pool (44) with an electron beam (42); and
the electron beam (42) is scanned over a central portion of the pool (44) and over a peripheral slag-covered portion.

3. The method of claim 1 or 2 wherein the frozen slag comprises at least an outboard 2-10% of the ingot radius.

4. The method of claim 1 or 2 wherein the frozen slag comprises at least an outboard 3-7% of the ingot radius.

5. The method of claim 1 or 2 wherein the frozen slag comprises at least an outboard 5% of the ingot radius.

6. The method of any preceding claim further comprising: providing a plasmatron (80) for generating a plasma within the chamber (22), said plasmatron (80) being arranged within the chamber (22) or on a wall of the chamber (22).

7. The method of claim 6 wherein:
the plasmatron comprises a pair of plasmatrons (80A, 80B).

8. The method of claim 7 further comprising: coupling a voltage source (84) across respective bodies (82) of the pair of plasmatrons (80A, 80B).

9. The method of claim 7 or 8 further comprising:
coupling an oxygen source (86) to the plasmatrons (80A, 80B).

10. The method of any preceding claim further comprising: providing an RF antenna (70) surrounding the space between the crucible (34) and the substrate.

11. The method of any preceding claim wherein the coating material consists essentially of one or more ceramics.

## Patentansprüche

1. Verfahren zum Aufbringen einer Beschichtung auf ein Substrat: wobei das Verfahren umfasst:
i) Bereitstellen einer Vorrichtung, aufweisend:
eine Abscheidungskammer (22);
einen gekühlten Tiegel (34) zum Aufnehmen eines Schmelzbads (44) aus Beschichtungsmaterial; und
Mittel (100) zum Drehen des Schmelzbads (44)
ii) Schmelzen eines Barrens (30) in dem Tiegel, um das Schmelzbad (44) zu bilden; und
iii) Steuern des Mittels (100) zum Drehen des Schmelzbads (44), um Schlacke, die auf der Badoberfläche schwimmt, radial zum Badaußenbreich zu bewegen und die Schlacke erstarren zu lassen.

2. Verfahren nach Anspruch 1, wobei:
das Schmelzen das Erwärmen des Schmelzbads (44) mit einem Elektronenstrahl (42) umfasst; und
der Elektronenstrahl (42) über einen zentralen Abschnitt des Bads (44) und über einen mit Schlacke bedeckten Außenbereich gefahren wird.

3. Verfahren nach Anspruch 1 oder 2, wobei die erstarrte Schlacke wenigstens einen Außenteil von 2 bis 10 % des Barrenradius umfasst.

4. Verfahren nach Anspruch 1 oder 2, wobei die erstarrte Schlacke wenigstens einen Außenteil von 3 bis 7 % des Barrenradius umfasst.

5. Verfahren nach Anspruch 1 oder 2, wobei die erstarrte Schlacke wenigstens einen Außenteil von 5 % des Barrenradius umfasst.

6. Verfahren nach einem der vorangehenden Ansprüche, ferner umfassend: Bereitstellen eines Plasmatrons (80) zum Erzeugen eines Plasmas in der Kammer (22), wobei das Plasmatron (80) in der Kammer (22) oder an einer Wand der Kammer (22) angeordnet wird.

7. Verfahren nach Anspruch 6, wobei:
das Plasmatron ein Paar Plasmatronen (80A, 80B) umfasst.

8. Verfahren nach Anspruch 7, ferner umfassend: Koppeln einer Spannungsquelle (84) an jeweilige Körper (82) des Paars Plasmatronen (80A, 80B).

9. Verfahren nach Anspruch 7 oder 8, ferner umfassend:
Koppeln einer Sauerstoffquelle (86) an die Plasmatronen (80A, 80B).

10. Verfahren nach einem der vorangehenden Ansprüche, ferner umfassend: Bereitstellen einer RF-Antenne (70), die den Raum zwischen dem Tiegel (34) und dem Substrat umgibt.

11. Verfahren nach einem der vorangehenden Ansprüche, wobei das Beschichtungsmaterial im Wesentlichen aus einer oder mehreren Keramiken besteht.

## Revendications

1. Procédé d'application de revêtement à un substrat, le procédé comprenant :
i) l'utilisation d'un appareil ayant :
une chambre de dépôt (22) ;
un creuset refroidi (34) pour contenir un bain de fusion (44) du matériau de revêtement ; et
un moyen (100) pour faire pivoter le bain de fusion (44)
ii) la fusion d'un lingot (30) dans le creuset pour former le bain de fusion (44) ; et
iii) le contrôle du moyen (100) de rotation du bain de fusion (44) afin de déplacer la scorie flottant sur la surface du bain radialement vers la périphérie du bain et pour congeler la scorie.

2. Procédé de la revendication 1, dans lequel :
la fusion comprend le chauffage du bain de fusion (44) avec un faisceau d'électrons (42) ; et
le faisceau d'électrons (42) est scanné sur une partie centrale du bain (44) et sur une partie périphérique recouverte de scorie.

3. Procédé de la revendication 1 ou 2, dans lequel la scorie congelée comprend au moins un dépassement de 2 à 10 % du rayon du lingot.

4. Procédé de la revendication 1 ou 2, dans lequel la scorie congelée comprend au moins un dépassement de 3 à 7 % du rayon du lingot.

5. Procédé de la revendication 1 ou 2, dans lequel la scorie congelée comprend au moins un dépassement 5 % du rayon du lingot.

6. Procédé d'une quelconque revendication précédente, comprenant :
l'utilisation d'un plasmatron (80) pour générer un plasma à l'intérieur de la chambre (22), ledit plasmatron (80) étant placé dans la chambre (22) ou sur une paroi de la chambre (22).

7. Procédé de la revendication 6, dans lequel :
le plasmatron comprend une paire de plasmatrons (80A, 80B).

8. Procédé de la revendication 7, comprenant également : le couplage d'une source de tension (84) à travers des corps respectifs (82) de la paire de plasmatrons (80A, 80B).

9. Procédé de la revendication 7 ou 8, comprenant également :
le couplage d'une source d'oxygène (86) aux plasmatrons (80A, 80B).

10. Procédé d'une quelconque revendication précédente, comprenant
également :
l'utilisation d'une antenne RF (70) entourant l'espace entre le creuset (34) et le substrat.

11. Procédé d'une quelconque revendication précédente, dans lequel le matériau de revêtement est composé essentiellement d'un ou de plusieurs céramiques.
